# FASCICULE DE BREVET EUROPEEN

(11) **EP 2 997 605 B1**
(45) Date de publication et mention de la délivrance du brevet: **06.09.2017**
(21) Numéro de dépôt: 14729421.9
(22) Date de dépôt: 13.05.2014
(51) Int. Cl.: H01L 33/00, H01L 33/04, H01L 33/14, H01L 33/18, H01L 33/32, H01L 31/0352, B82Y 20/00, H01L 33/08, H01L 33/24

(54) **DISPOSITIF OPTOÉLECTRONIQUE ET SON PROCÉDÉ DE FABRICATION**
OPTOELEKTRONISCHE VORRICHTUNG UND HERSTELLUNGSVERFAHREN DAFÜR
OPTOELECTRONIC DEVICE AND METHOD OF MANUFACTURING THE SAME

(30) Priorité: 14.05.2013 FR 1354287
(43) Date de publication de la demande: 23.03.2016
(73) Titulaire: Aledia, 38040 Grenoble Cedex (FR); Commissariat à l'Energie Atomique et aux Energies Alternatives, 75015 Paris (FR)
(72) Inventeur: GILET, Philippe, F-38470 Teche (FR); TCHELNOKOV, Alexei, F-38240 Meylan (FR); ROBIN, Ivan-Christophe, F-38000 Grenoble (FR)
(74) Mandataire: Thibon, Laurent
(86) Numéro de dépôt international: PCT/FR2014/051111
(87) Numéro de publication internationale: WO 2014/184487

(56) Documents cités:
- EP-A1- 0 544 512
- EP-A2- 0 803 948
- WO-A1-00/45443
- WO-A1-2009/072631
- US-A1- 2011 140 072
- US-A1- 2012 001 303
- KRAMES M R ET AL: "High-power truncated-inverted-pyramid (AlxGa1-x)0.5In0.5P/GaP light-emitting diodes exhibiting >50% external quantum efficiency", APPLIED PHYSICS LETTERS, AMERICAN INSTITUTE OF PHYSICS, US, vol. 75, no. 16, 18 octobre 1999 (1999-10-18), pages 2365-2367, XP012023753, ISSN: 0003-6951, DOI: 10.1063/1.125016

## Description

La présente demande de brevet revendique la priorité de la demande de brevet français FR13/54287.

### Domaine

La présente invention concerne de façon générale les dispositifs optoélectroniques à base de matériaux semiconducteurs et leurs procédés de fabrication. La présente invention concerne plus particulièrement les dispositifs optoélectroniques comprenant des éléments tridimensionnels, notamment des microfils ou nanofils semiconducteurs.

### Exposé de l'art antérieur

Des exemples de microfils ou nanofils comprenant un matériau semiconducteur sont les microfils ou nanofils à base d'un composé comportant majoritairement au moins un élément du groupe III et un élément du groupe V (par exemple du nitrure de gallium GaN), appelé par la suite composé III-V, ou comportant majoritairement au moins un élément du groupe II et un élément du groupe VI (par exemple de l'oxyde de zinc ZnO), appelé par la suite composé II-VI. De tels microfils ou nanofils permettent la fabrication de dispositifs semiconducteurs tels que des dispositifs optoélectroniques. Par dispositifs optoélectroniques, on entend des dispositifs adaptés pour effectuer la conversion d'un signal électrique en un rayonnement électromagnétique ou inversement, et notamment des dispositifs dédiés à la détection, la mesure ou l'émission d'un rayonnement électromagnétique ou des dispositifs dédiés aux applications photovoltaïques.

L'intégration monolithique d'une jonction tunnel dans un dispositif optoélectronique, une diode électroluminescente par exemple, est connue du document de l'art antérieur: EP 0 803 948 A2.

### Résumé

La présente invention concerne un dispositif optoélectronique comprenant :
un substrat semiconducteur dopé d'un premier type de conductivité ;
des plots semiconducteurs ou une couche semiconductrice sur une face du substrat et en contact avec le substrat, dopés, respectivement dopée, d'un second type de conductivité opposé au premier type; et des éléments semiconducteurs tridimensionnels, chaque élément semiconducteur étant en contact avec un plot ou avec la couche;
dispositif dans lequel le substrat est en un premier matériau semiconducteur choisi parmi le groupe comprenant le silicium, le germanium, un alliage silicium-germanium, le carbure de silicium, un composé III-V, tel que du GaN, du GaAs, du GaP ou du GaSb, ou le ZnO et une combinaison de ces composés,
dans lequel les plots semiconducteurs ou la couche semiconductrice sont en un matériau choisi parmi le groupe comprenant le nitrure d'aluminium, le nitrure de bore, le carbure de silicium, le nitrure de magnésium, le nitrure de gallium et de magnésium ou en une combinaison de ceux-ci et de leurs composés nitrurés,
dans lequel chaque élément semiconducteur est au moins partiellement recouvert d'une structure semiconductrice adaptée à émettre ou capter de la lumière,
dans lequel la concentration de dopants des plots ou de la couche est strictement supérieure à 10¹⁹ atomes/cm³ et dans lequel la concentration de dopants du substrat est strictement supérieure à 10¹⁹ atomes/cm³ .

Selon un mode de réalisation, chaque élément semiconducteur comprend au moins une partie, en contact avec le plot associé ou la couche, dopée du second type de conductivité.

Selon un mode de réalisation, la concentration de dopants des éléments semiconducteurs est strictement supérieure à 10¹⁹ atomes/cm³.

Selon un mode de réalisation, le dispositif comprend, en outre, une portion recouvrant au moins les flancs latéraux de chaque plot, ladite portion empêchant la croissance des éléments semiconducteurs sur les flancs latéraux.

Selon un mode de réalisation, le dispositif comprend, en outre, une région diélectrique s'étendant dans le substrat depuis ladite face et reliant, pour chaque paire de plots, l'un des plots de la paire à l'autre plot de la paire.

Selon un mode de réalisation, le substrat est en silicium, notamment en silicium monocristallin.

Selon un mode de réalisation, ladite partie comprend majoritairement un deuxième matériau semiconducteur choisi parmi le groupe comprenant le silicium, le germanium, le carbure de silicium, un composé III-V, un composé II-VI et une combinaison de ces composés.

Selon un mode de réalisation, l'épaisseur de chaque plot est comprise entre 1 nm et 100 nm et le substrat est en contact électrique avec chaque plot.

Selon un mode de réalisation, chaque élément semiconducteur est un microfil, un nanofil ou un élément conique ou tronconique à base polygonale.

Un mode de réalisation comprend un procédé de fabrication d'un dispositif optoélectronique, comprenant les étapes successives suivante :
prévoir un substrat semiconducteur dopé d'un premier type de conductivité ;
former, sur une face du substrat et en contact avec le substrat, des plots semiconducteurs ou une couche semiconductrice dopés, respectivement dopée, d'un second type de conductivité opposé au premier type ; et
former des éléments semiconducteurs tridimensionnels, chaque élément semiconducteur étant en contact avec un plot ou avec la couche,
dans lequel le substrat est en un premier matériau semiconducteur choisi parmi le groupe comprenant le silicium, le germanium, un alliage silicium-germanium, le carbure de silicium, un composé III-V, tel que du GaN, du GaAs, du GaP ou du GaSb, ou le ZnO et une combinaison de ces composés,
dans lequel les plots semiconducteurs ou la couche semiconductrice sont en un matériau choisi parmi le groupe comprenant le nitrure d'aluminium, le nitrure de bore, le carbure de silicium, le nitrure de magnésium, le nitrure de gallium et de magnésium ou en une combinaison de ceux-ci et de leurs composés nitrurés,
dans lequel chaque élément semiconducteur est au moins partiellement recouvert d'une structure semiconductrice adaptée à émettre ou capter de la lumière,
dans lequel la concentration de dopants des plots ou de la couche est strictement supérieure à 10¹⁹ atomes/cm³ et dans lequel la concentration de dopants du substrat est strictement supérieure à 10 atomes/cm³.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une coupe, partielle et schématique, d'un exemple d'un dispositif optoélectronique à microfils ou nanofils ne définissant pas, à lui seul, la présente invention ;
les figures 2 et 3 représentent des courbes d'évolution du courant traversant chaque microfil ou nanofil du dispositif optoélectronique de la figure 1 en fonction de la tension de polarisation entre les électrodes du dispositif ;
la figure 4 est une coupe, partielle et schématique, d'un mode de réalisation d'un dispositif optoélectronique à microfils ou nanofils en accord avec la présente invention ;
les figures 5A à 5I sont des coupes, partielles et schématiques, des structures obtenues à des étapes successives d'un mode de réalisation d'un procédé, selon la présente invention, de fabrication du dispositif optoélectronique de la figure 4 ;
les figures 6 et 7 représentent des courbes d'évolution du courant traversant chaque nanofil ou microfil du dispositif optoélectronique de la figure 4 en fonction de la tension appliquée entre les électrodes du dispositif ; et
la figure 8 est une coupe, partielle et schématique, d'un autre mode de réalisation d'un dispositif optoélectronique à microfils ou nanofils selon la présente invention.

### Description détaillée

Par souci de clarté, de mêmes éléments ont été désignés par de mêmes références aux différentes figures et, de plus, comme cela est habituel dans la représentation des circuits électroniques, les diverses figures ne sont pas tracées à l'échelle. En outre, seuls les éléments utiles à la compréhension de la présente description ont été représentés et sont décrits. En particulier, les moyens de commande des dispositifs optoélectroniques décrits ci-après sont à la portée de l'homme de l'art et ne sont pas décrits.

Dans la suite de la description, sauf indication contraire, les termes "sensiblement", "environ" et "de l'ordre de" signifient "à 10 % près". En outre, on entend par "composé principalement constitué d'un matériau" ou "composé à base d'un matériau" qu'un composé comporte une proportion supérieure ou égale à 95 % dudit matériau, cette proportion étant préférentiellement supérieure à 99 %.

La présente invention concerne la fabrication d'éléments tridimensionnels, par exemple de microfils, de nanofils ou d'éléments en forme de pyramide, dans le cadre de dispositifs optoélectroniques les incorporant. Dans la suite de la description, des modes de réalisation sont décrits pour la fabrication de microfils ou de nanofils. Toutefois, ces modes de réalisation peuvent être mis en oeuvre pour la fabrication d'éléments tridimensionnels autres que des microfils ou des nanofils, par exemple pour la fabrication d'éléments tridimensionnels en forme de pyramide.

Le terme "microfil" ou "nanofil" désigne une structure tridimensionnelle de forme allongée selon une direction privilégiée dont au moins deux dimensions, appelées dimensions mineures, sont comprises entre 5 nm et 2,5 µm, de préférence entre 50 nm et 2,5 µm, la troisième dimension, appelée dimension majeure, étant au moins égale à 1 fois, de préférence au moins 5 fois et encore plus préférentiellement au moins 10 fois, la plus grande des dimensions mineures. Dans certains modes de réalisation, les dimensions mineures peuvent être inférieures ou égales à environ 1 µm, de préférence comprises entre 100 nm et 1 µm, plus préférentiellement entre 100 nm et 300 nm. Dans certains modes de réalisation, la hauteur de chaque microfil ou nanofil peut être supérieure ou égale à 500 nm, de préférence comprise entre 1 µm et 50 µm.

Dans la suite de la description, on utilise le terme "fil" pour signifier "microfil ou nanofil". De préférence, la ligne moyenne du fil qui passe par les barycentres des sections droites, dans des plans perpendiculaires à la direction privilégiée du fil, est sensiblement rectiligne et est appelée par la suite "axe" du fil.

La section droite des fils peut avoir différentes formes, telles que, par exemple, une forme ovale, circulaire ou polygonale, notamment triangulaire, rectangulaire, carrée ou hexagonale. Ainsi, on comprend que, quand on mentionne ici le "diamètre" dans une section droite d'un fil ou d'une couche déposée sur ce fil, il s'agit d'une grandeur associée à la surface de la structure visée dans cette section droite, correspondant, par exemple, au diamètre du disque ayant la même surface que la section droite du fil.

Les fils peuvent être, au moins en partie, formés à partir d'au moins un matériau semiconducteur. Le matériau semiconducteur peut être du silicium, du germanium, du carbure de silicium, un composé III-V, un composé II-VI ou une combinaison de ces composés.

Les fils peuvent être, au moins en partie, formés à partir de matériaux semiconducteurs comportant majoritairement un composé III-V, par exemple des composés III-N. Des exemples d'éléments du groupe III comprennent le gallium (Ga), l'indium (In) ou l'aluminium (Al). Des exemples de composés III-N sont GaN, AIN, InN, InGaN, AlGaN ou AlInGaN. D'autres éléments du groupe V peuvent également être utilisés, par exemple, le phosphore ou l'arsenic. De façon générale, les éléments dans le composé III-V peuvent être combinés avec différentes fractions molaires.

Les fils peuvent être, au moins en partie, formés à partir de matériaux semiconducteurs comportant majoritairement un composé II-VI. Des exemples d'éléments du groupe II comprennent des éléments du groupe IIA, notamment le béryllium (Be) et le magnésium (Mg) et des éléments du groupe IIB, notamment le zinc (Zn) et le cadmium (Cd). Des exemples d'éléments du groupe VI comprennent des éléments du groupe VIA, notamment l'oxygène (O) et le tellure (Te). Des exemples de composés II-VI sont ZnO, ZnMgO, CdZnO ou CdZnMgO. De façon générale, les éléments dans le composé II-VI peuvent être combinés avec différentes fractions molaires.

Dans certains modes de réalisation, les fils peuvent comprendre un dopant. A titre d'exemple, pour des composés III-V, le dopant peut être choisi parmi le groupe comprenant un dopant de type P du groupe II, par exemple, du magnésium (Mg), du zinc (Zn), du cadmium (Cd) ou du mercure (Hg), un dopant du type P du groupe IV, par exemple du carbone (C) ou un dopant de type N du groupe IV, par exemple du silicium (Si), du germanium (Ge), du sélénium (Se), du soufre (S), du terbium (Tb) ou de l'étain (Sn).

Les fils sont formés sur un substrat. Selon l'exemple qui suit, le substrat peut correspondre à une structure monobloc ou correspondre à une couche recouvrant un support constitué d'un autre matériau. Selon la présente invention, le substrat est en un matériau semiconducteur, tel qu'un substrat en silicium, en germanium, en alliage de silicium-germanium, en carbure de silicium, en un composé III-V, tel que du GaN, du GaAs, du GaP ou du GaSb, ou un substrat en ZnO ou une combinaison de ces composés.

Une couche de germination ou des plots ou îlots, appelés également par la suite îlots de germination, sont formés sur une face du substrat. La couche de germination ou les îlots de germination sont en un matériau favorisant la croissance des fils. Dans le cas d'îlots de germination, un traitement est, en outre, prévu pour protéger les flancs latéraux des îlots de germination et la surface des parties du substrat non recouvertes par les îlots de germination pour former une région diélectrique sur les flancs latéraux des îlots de germination et s'étendant sur et/ou dans le substrat et reliant, pour chaque paire de plots, l'un des plots de la paire à l'autre plot de la paire, les fils ne croissant pas sur la région diélectrique.

Le fait de dire qu'un composé à base d'au moins un premier élément et d'un deuxième élément a une polarité du premier élément ou une polarité du deuxième élément signifie que le matériau croît selon une direction privilégiée et que lorsque le matériau est coupé dans un plan perpendiculaire à la direction de croissance privilégiée, la face exposée comprend essentiellement des atomes du premier élément dans le cas de la polarité du premier élément ou des atomes du deuxième élément dans le cas de la polarité du deuxième élément.

Le matériau constituant la couche de germination ou les îlots de germination est choisi de façon à favoriser la croissance des fils selon la même polarité. A titre d'exemple, lorsque les fils comprennent majoritairement un composé III-V, le matériau constituant les îlots de germination est choisi de préférence de façon à favoriser la croissance du composé III-V selon la polarité de l'élément du groupe V. Le composé III-V croît alors selon la polarité de l'élément du groupe V sur les îlots de germination, depuis le sommet de chaque îlot de germination, et ne croît ni sur les flancs latéraux des îlots de germination ni sur le reste du substrat. En outre, les inventeurs ont mis en évidence que chaque fil croît alors selon une polarité sensiblement constante dans la totalité du fil. Lorsque les fils comprennent majoritairement un composé II-VI, le matériau constituant les îlots de germination est choisi de préférence de façon à favoriser la croissance du composé II-VI selon la polarité de l'élément du groupe VI. Le composé II-VI croît alors selon la polarité de l'élément du groupe VI sur les îlots de germination, depuis le sommet de chaque îlot de germination, et ne croît ni sur les flancs latéraux des îlots de germination ni sur le reste du substrat.

Dans le cas d'un composé III-V dans lequel l'élément du groupe V est l'azote, le matériau composant les îlots peut être un matériau favorisant la croissance d'un fil selon la polarité N. A titre d'exemple, en accord avec la présente invention, les îlots, ou plots, sont réalisés en nitrure d'aluminium (AlN), en nitrure de bore (BN), en carbure de silicium (SiC), en nitrure de magnésium sous la forme MgₓN_{y}, où x est environ égal à 3 et y est environ égal à 2, par exemple du nitrure de magnésium selon la forme Mg₃N₂ ou du nitrure de gallium et de magnésium (MgGaN), ou en une combinaison de ceux-ci et de leurs composés nitrurés. De préférence, le matériau composant les îlots de germination est le nitrure d'aluminium.

Le procédé de croissance des fils peut être un procédé du type dépôt chimique en phase vapeur (CVD, sigle anglais pour Chemical Vapor Déposition) ou dépôt chimique en phase vapeur organométallique (MOCVD, acronyme anglais pour Metal-Organic Chemical Vapor Déposition), également connu sous le nom d'épitaxie organométallique en phase vapeur (ou MOVPE, acronyme anglais pour Metal-Organic Vapor Phase Epitaxy). Toutefois, des procédés tels que l'épitaxie par jets moléculaires (MBE, acronyme anglais pour Molecular-Beam Epitaxy), la MBE à source de gaz (GSMBE), la MBE organométallique (MOMBE), la MBE assistée par plasma (PAMBE), l'épitaxie par couche atomique (ALE, acronyme anglais pour Atomic Layer Epitaxy) ou l'épitaxie en phase vapeur aux hydrures (HVPE, acronyme anglais pour Hydride Vapor Phase Epitaxy) peuvent être utilisés. Toutefois, des procédés électrochimiques peuvent être utilisés, par exemple, le dépôt en bain chimique (CBD, sigle anglais pour Chemical Bath Déposition), les procédés hydrothermiques, la pyrolise d'aérosol liquide ou l'électrodépôt.

A titre d'exemple, le procédé peut comprendre l'injection dans un réacteur d'un précurseur d'un élément du groupe III et d'un précurseur d'un élément du groupe V. Des exemples de précurseurs d'éléments du groupe III sont le triméthylgallium (TMGa), le triéthylgallium (TEGa), le triméthylindium (TMIn) ou le triméthylaluminium (TMAl). Des exemples de précurseurs d'éléments du groupe V sont l'ammoniac (NH₃), la tertiarybutylphosphine (TBP), l'arsine (AsH₃), ou la diméthylhydrazine asymétrique (UDMH).

Selon un mode de réalisation de l'invention, telle que définie par les présentes revendications, dans une première phase de croissance des fils du composé III-V, un précurseur d'un élément supplémentaire est ajouté en excès en plus des précurseurs du composé III-V. L'élément supplémentaire peut être le silicium (Si). Un exemple de précurseur du silicium est le silane (SiH₄).

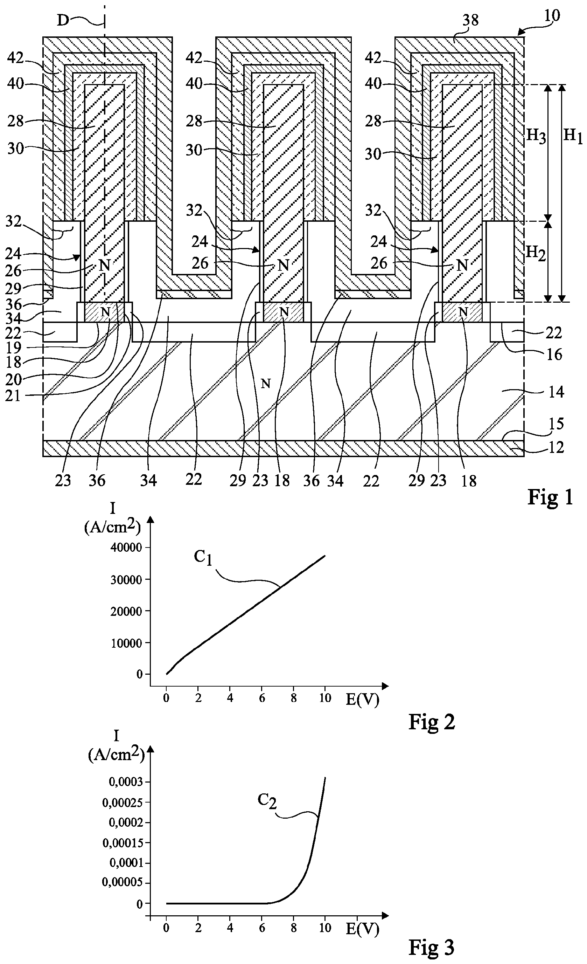

La figure 1 est une coupe, partielle et schématique, d'un exemple d'un dispositif optoélectronique 10 réalisé à partir de fils tels que décrits précédemment et adapté à l'émission d'un rayonnement électromagnétique.

Le dispositif 10 comprend, du bas vers le haut en figure 1 :
une première électrode de polarisation 12 ;
un substrat semiconducteur 14 comprenant des faces opposées 15 et 16, la face 15 étant au contact de l'électrode 12 ;
des îlots de germination 18 favorisant la croissance de fils et disposés sur la face 16, chaque îlot 18 comprenant une face inférieure 19 en contact avec la face 16 du substrat 14, une face supérieure 20, opposée à la face 19, et à distance de la face 19 et des faces latérales 21, ou flancs latéraux, reliant la face inférieure 19 à la face supérieure 20 ;
une région 22 dans le substrat 14, s'étendant entre chaque paire d'îlots 18 depuis la face 16 sur une partie de la profondeur du substrat 14, la région 22 étant constituée d'un diélectrique, issu de la transformation du substrat, qui protège le substrat sous-jacent et empêche la croissance de fils ;
des portions isolantes 23 recouvrant les faces latérales 21 et entourant chaque îlot 18, les portions isolantes 23 empêchant la croissance de fils ;
des fils 24 (trois fils étant représentés) de hauteur H₁, chaque fil 24 étant en contact avec la face 20 de l'un des îlots 18, chaque fil 24 comprenant une portion inférieure 26, de hauteur H₂, en contact avec l'îlot 18 et une portion supérieure 28, de hauteur H₃, en contact avec la portion inférieure 26 ;
une couche passivante 29 recouvrant la périphérie de chaque portion inférieure 26 ;
une couche active 30 recouvrant chaque portion supérieure 28 ;
une couche semiconductrice 32 ou davantage recouvrant chaque couche active 30 ;
des portions isolantes 34 recouvrant la face 16 entre les fils 24 et chaque fil 24 sur au moins la hauteur H₂ ;
une portion réfléchissante 36 recouvrant les portions isolantes 34 entre les fils 24 ; et
une couche de seconde électrode 38 recouvrant les couches semiconductrices 32 et les portions isolantes 34.
Le substrat 14 est, par exemple, un substrat semiconducteur, tel qu'un substrat en silicium. Le substrat 14 est dopé d'un premier type de conductivité, par exemple dopé de type N. Les faces 15 et 16 peuvent être planes et parallèles. La face 16 du substrat 14 peut être une face <100>.

L'électrode 12 peut correspondre à une couche conductrice qui s'étend sur la face 15 du substrat 14. Le matériau formant l'électrode 12 est, par exemple, du siliciure de nickel (NiSi), de l'aluminium (Al), du siliciure d'aluminium (AlSi), du titane (Ti) ou du siliciure de titane (TiSi). Cette couche peut être recouverte d'une autre couche métallique, par exemple de l'or, du cuivre ou des eutectiques (Ti/Ni/Au ou Sn/Ag/Cu) en cas de brasure.

Les îlots 18 sont situés sur la face 16 de sorte qu'ils soient en saillie par rapport à la face 16. Le sommet 20 de chaque îlot 18 est donc dans un plan différent de la face 16. Chaque îlot 18 a une texturation préférentielle et, lorsque le matériau composant chaque îlot comprend un alliage d'au moins deux éléments, une polarité préférentielle. Par texturation préférentielle, on entend que les cristaux qui composent les îlots 18 ont une direction de croissance privilégiée qui est la même pour tous les îlots 18. Par polarité préférentielle, on entend que les îlots 18 ont sensiblement tous la même polarité. Ceci signifie que lorsque le matériau composant chaque îlot comprend un alliage d'au moins deux éléments, lorsque le matériau est coupé dans un plan perpendiculaire à la direction de croissance privilégiée du matériau, la surface exposée comprend essentiellement des atomes du même élément pour chaque îlot 18. Chaque îlot 18 présente le même type de conductivité que le substrat 14 afin de réduire la résistance d'interface entre les îlots 18 et le substrat 14. Chaque îlot 18 peut avoir une forme quelconque, par exemple rectangulaire, polygonale, circulaire, carrée ou ovale. De préférence, le diamètre moyen de l'îlot de germination 18 est du même ordre de grandeur que le diamètre moyen du fil 24 destiné à croître sur l'îlot de germination 18.

Les portions isolantes 23 peuvent être constituées d'un matériau déposé sur les flancs 21 des îlots de germination 18. Il peut s'agir de matériaux déposés de façon conforme, par exemple par CVD. Il s'agit, par exemple, d'oxyde de silicium (SiO₂), de nitrure de silicium (SiₓNy, où x est environ égal à 3 et y est environ égal à 4, par exemple du Si₃N₄), d'oxyde d'aluminium (Al₂O₃), d'oxyde d'hafnium (HfO₂) ou de diamant. Les portions isolantes 23 peuvent, en outre, être constituées d'un matériau diélectrique issu de la transformation du matériau constituant les îlots de germination 18. Le matériau constituant les portions de protection 23 peut alors correspondre à un oxyde des exemples de matériaux des îlots de germination 18 décrits précédemment. A titre d'exemple, l'épaisseur des portions isolantes 23 est comprise entre 5 nm et 100 nm, par exemple égale à environ 30 nm.

La région 22 peut s'étendre partiellement sous certains îlots 18 ou sous chaque îlot 18. Toutefois, le substrat semiconducteur 14 doit rester en contact électrique avec chaque îlot 18. Les conditions de formation des régions 22 sont donc choisies de façon que les régions 22 s'étendent au plus sur une longueur inférieure à la moitié de la plus grande longueur de la section du fil. A titre d'exemple, la profondeur de chaque région 22 est comprise entre 5 nm et 100 nm, par exemple 10 nm.

Les centres de deux îlots 18 adjacents peuvent être distants de 0,5 µm à 10 µm et de préférence de 1,5 à 4 µm. A titre d'exemple, les îlots 18 peuvent être régulièrement répartis sur le substrat 14, la région 22 formant un quadrillage entourant chaque îlot 18. A titre d'exemple, les îlots 18 peuvent être répartis selon un réseau hexagonal.

Chaque fil 24 a une structure semiconductrice allongée selon un axe D sensiblement perpendiculaire à la face 16. Chaque fil 24 peut avoir une forme générale cylindrique allongée à base hexagonale. Le diamètre moyen de chaque fil 24 peut être compris entre 50 nm et 2,5 µm et la hauteur H₁ de chaque fil 24 peut être comprise entre 250 nm et 50 µm.

La portion inférieure 26 de chaque fil 24 est principalement constituée du composé III-N, par exemple du nitrure de gallium, dopé du premier type de conductivité, par exemple au silicium. Le pourtour de la portion inférieure 26 est recouvert par la couche 29 de diélectrique, par exemple du SiN, sur la hauteur H₂ depuis l'extrémité de la portion inférieure 26 au contact avec l'îlot 18 associé. La hauteur H₂ peut être comprise entre 100 nm et 25 µm. La couche de matériau diélectrique 29 a une épaisseur comprise entre une monocouche atomique et 100 nm, de préférence entre une monocouche atomique et 10 nm.

La portion supérieure 28 de chaque fil 24 est, par exemple, au moins partiellement réalisée dans un composé III-N, par exemple du GaN. La portion supérieure 28 peut être dopée du premier type de conductivité, ou ne pas être intentionnellement dopée. La portion supérieure 28 s'étend sur la hauteur H₃ qui peut être comprise entre 100 nm et 25 µm.

Dans le cas d'un fil composé principalement de GaN, la structure cristalline du fil peut être du type wurtzite, le fil s'étendant selon l'axe C. La structure cristalline du fil peut également être du type cubique.

La couche active 30 est la couche depuis laquelle est émise la majorité du rayonnement fourni par le dispositif 10. Selon un exemple, la couche active 30 peut comporter des moyens de confinement, tels que des puits quantiques multiples. Elle est, par exemple, constituée d'une alternance de couches de GaN et de InGaN ayant des épaisseurs respectives de 5 à 20 nm (par exemple 8 nm) et de 1 à 10 nm (par exemple 2,5 nm). Les couches de GaN peuvent être dopées, par exemple de type N ou P. Selon un autre exemple, la couche active peut comprendre une seule couche d'InGaN, par exemple d'épaisseur supérieure à 10 nm.

La couche semiconductrice 32 permet la formation d'une jonction P-N ou P-I-N avec la couche active 30 et/ou la portion supérieure 28. Elle permet l'injection de trous dans la couche active 30 via l'électrode 38.

L'empilement de couches semiconductrices 32 peut comprendre une couche de blocage d'électrons 40 formée d'un alliage ternaire, par exemple en nitrure de gallium et d'aluminium (AlGaN) ou en nitrure d'indium et d'aluminium (AlInN) en contact avec la couche active 30 et une couche supplémentaire 42, pour assurer un bon contact électrique entre la deuxième électrode 38 et la couche active 30, par exemple en nitrure de gallium (GaN) en contact avec la couche de blocage d'électrons 40 et avec l'électrode 38. La couche semiconductrice 42 est dopée du type de conductivité opposé à celui de la portion 28, par exemple dopée de type P. La couche de blocage d'électrons 40 peut être du même type de conductivité que la couche semiconductrice 42.

Les portions isolantes 34 sont adaptées à empêcher la formation d'un contact électrique direct entre la portion inférieure 26 de chaque fil 24 et l'électrode 38. Les portions isolantes 34 peuvent être déposées de façon conforme, par exemple par CVD. Les portions isolantes 34 peuvent être en un matériau diélectrique, par exemple en oxyde de silicium (SiO₂), en nitrure de silicium (SiₓN_{y}, où x est environ égal à 3 et y est environ égal à 4, par exemple du Si₃N₄), en oxyde d'aluminium (Al₂O₃), en oxyde d'hafnium (HfO₂) ou en diamant.

Les portions réfléchissantes 36 sont réalisées, par exemple, en aluminium, en argent ou en ruthénium et ont, par exemple, une épaisseur supérieure à 100 nm.

La deuxième électrode 38 est adaptée pour polariser la couche active 30 de chaque fil 24 et laisser passer le rayonnement électromagnétique émis ou reçu par les fils 24. Le matériau formant l'électrode 38 peut être un matériau transparent et conducteur tel que de l'oxyde d'indium-étain (ou ITO, acronyme anglais pour Indium Tin Oxide), de l'oxyde de zinc dopé à l'aluminium ou du graphène.

Dans le présent exemple, les fils 24 sont réalisés sur des îlots 18 qui sont des éléments séparés répartis sur le substrat 14. A titre de variante, les îlots de germination 18 peuvent être remplacés par une couche de germination recouvrant la face 16 du substrat 14. La couche de germination peut être recouverte d'une couche isolante comprenant des ouvertures qui exposent des portions de la couche de germination, les fils croissant sur les portions exposées de la couche de germination.

Les îlots de germination 18, ou la couche de germination, doivent satisfaire plusieurs contraintes.

Premièrement, les îlots de germination 18 ou la couche de germination doivent permettre la croissance des fils 24.

Deuxièmement, les îlots de germination 18 ou la couche de germination doivent empêcher la diffusion de l'élément du groupe III, en particulier le gallium, depuis chaque fil 24 vers le substrat 14. En effet, la diffusion de l'élément du groupe III dans le substrat 14 entraînerait la création d'un alliage de silicium et de l'élément du groupe III qui est néfaste pour l'obtention de matériaux de bonne qualité pour la réalisation d'un dispositif optoélectronique.

Troisièmement, les îlots de germination 18 ou la couche de germination doivent permettre le passage d'un courant entre chaque fil 24 et le substrat 14 lorsque les électrodes 12 et 38 sont polarisées de façon convenable. Toutefois, les matériaux utilisés actuellement pour la réalisation des îlots de germination 18 ou de la couche de germination ont généralement des propriétés isolantes. C'est le cas du nitrure d'aluminium (AlN). L'épaisseur de chaque îlot de germination 18 ou de la couche de germination doit donc être suffisamment faible pour que les électrons puissent la traverser par effet tunnel. Dans ce but, l'épaisseur de chaque îlot de germination 18 ou de la couche de germination est de façon générale inférieure à 2 nm.

La figure 2 représente une courbe C₁ d'évolution de l'intensité du courant surfacique, exprimé en A/cm², traversant des îlots de germination 18 d'épaisseur 1 nm en fonction de la tension appliquée entre les électrodes 38 et 12. La courbe C₁ a été obtenue avec un substrat 14 de silicium dopé de type N avec une concentration de dopants de 10¹⁹ atomes/cm³, avec des îlots de germination de AlN dopés de type N avec une concentration de dopants de 10¹⁷ atomes/cm³. La courbe C₁ met en évidence le passage d'un courant au travers des îlots de germination 18.

La figure 3 représente une courbe C₂ d'évolution de l'intensité du courant surfacique traversant des îlots de germination 18, obtenue pour un dispositif optoélectronique identique à celui qui a été utilisé pour obtenir la courbe C₁ de la figure 2 à la différence que l'épaisseur de chaque îlot de germination 18 est d'environ 5 nm. Comme cela apparaît en figure 3, lorsque l'épaisseur des îlots de germination 18 est trop importante, il n'est pas observé de passage de courant au travers des îlots de germination 18 pour une tension de polarisation inférieure à 10 V.

Le passage par effet tunnel des électrons au travers des îlots de germination 18 est favorisé lorsque le substrat 14, les îlots de germination 18, et les portions inférieures 26 des fils 24 sont fortement dopés au moins au niveau des interfaces entre ces régions. Un problème supplémentaire apparaît alors dans le cas où le substrat est en silicium. En effet, lorsque les îlots de germination 18 sont en AlN, de l'aluminium peut diffuser vers le substrat en silicium 14. L'aluminium est un dopant de type P pour le silicium. De ce fait, la diffusion de l'aluminium dans le substrat 14 tend à diminuer la valeur du dopage de type N du substrat 14 au niveau de l'interface entre le substrat 14 et les îlots de germination 18. L'amélioration du passage par effet tunnel des électrons au travers des îlots de germination 18 due à l'augmentation des concentrations de dopants de type N n'est alors pas obtenue.

Ainsi, un objet d'un mode de réalisation est de pallier au moins en partie les inconvénients des dispositifs optoélectroniques, notamment à microfils ou nanofils, et de leurs procédés de fabrication décrits précédemment.

Un autre objet d'un mode de réalisation est que le passage du courant au travers de chaque îlot de germination ou de la couche de germination est amélioré, en particulier que le courant puisse passer au travers de chaque îlot de germination ou de la couche de germination lorsque les îlots de germination ou la couche de germination ont une épaisseur supérieure à 2 nm.

Un autre objet d'un mode de réalisation est que chaque élément tridimensionnel, notamment chaque fil, en matériau semiconducteur ait sensiblement une structure monocristalline.

Un autre objet d'un mode de réalisation est que la position, la géométrie et les propriétés cristallographiques de chaque élément tridimensionnel, notamment chaque fil, en matériau semiconducteur puissent être contrôlées de façon précise et uniforme.

Un autre objet d'un mode de réalisation est que les éléments tridimensionnels, notamment les fils, en matériau semiconducteur puissent être formés à une échelle industrielle et à bas coût.

Selon un mode de réalisation, on prévoit d'utiliser un substrat semiconducteur dopé d'un type de conductivité opposé au type de conductivité des îlots de germination ou de la couche de germination et de la portion inférieure des fils. On obtient ainsi une jonction tunnel à l'interface entre chaque îlot de germination et le substrat.

Un avantage est que l'épaisseur des îlots de germination ou de la couche de germination peut être augmentée.

De façon avantageuse, les îlots de germination ou la couche de germination sont dopés de type N et le substrat est dopé de type P. La diffusion de l'aluminium depuis les îlots de germination vers le substrat sous-jacent tend alors à accroître le dopage du substrat à l'interface entre le substrat et les îlots de germination ce qui est favorable à la formation de la jonction tunnel.

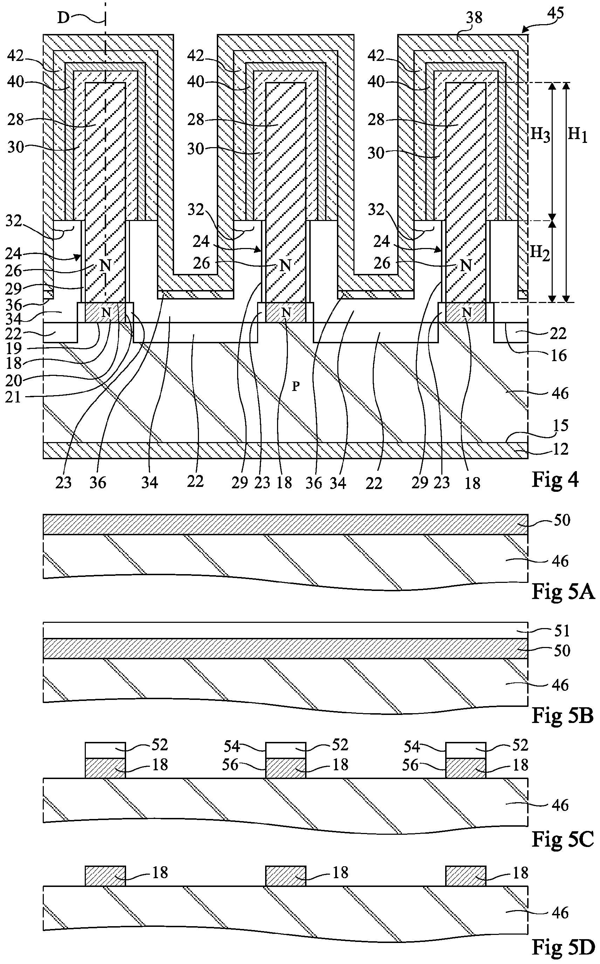

La figure 4 est une coupe, partielle et schématique, d'un mode de réalisation selon l'invention d'un dispositif optoélectronique 45 réalisé à partir de fils, tel que décrit précédemment et adapté à l'émission d'un rayonnement électromagnétique.

Le dispositif optoélectronique 45 comprend l'ensemble des éléments du dispositif optoélectronique 10 décrit précédemment en relation avec la figure 1 à l'exception que le substrat 14 dopé de type N est remplacé par un substrat 46 dopé de type P. La concentration de dopants de type P du substrat 46 est strictement supérieure à 10¹⁹ atomes/cm³, de préférence comprise entre 10¹⁹ atomes/cm³ et 10²¹ atomes/cm³.

Les îlots, ou plots 18 ont, par exemple, une épaisseur comprise entre 1 et 500 nanomètres, de préférence comprise entre 1 et 60 nanomètres, plus préférentiellement entre 1 nm et 10 nm, encore plus préférentiellement entre 2 nm et 5 nm. La concentration de dopants de type N de chaque îlot de germination 18 est strictement supérieure à 10¹⁹ atomes/cm³, de préférence comprise entre 10¹⁹ atomes/cm³ et 10²¹ atomes/cm³.

La concentration de dopants de type N de la portion inférieure 26 du fil 24 est strictement supérieure à 10¹⁹ atomes/cm³, de préférence comprise entre 10¹⁹ atomes/cm³ et 10²¹ atomes/cm³.

Les figures 5A à 5I illustrent les structures obtenues à des étapes successives d'un mode de réalisation d'un procédé, selon la présente invention, de fabrication du dispositif optoélectronique 45 de la figure 4.

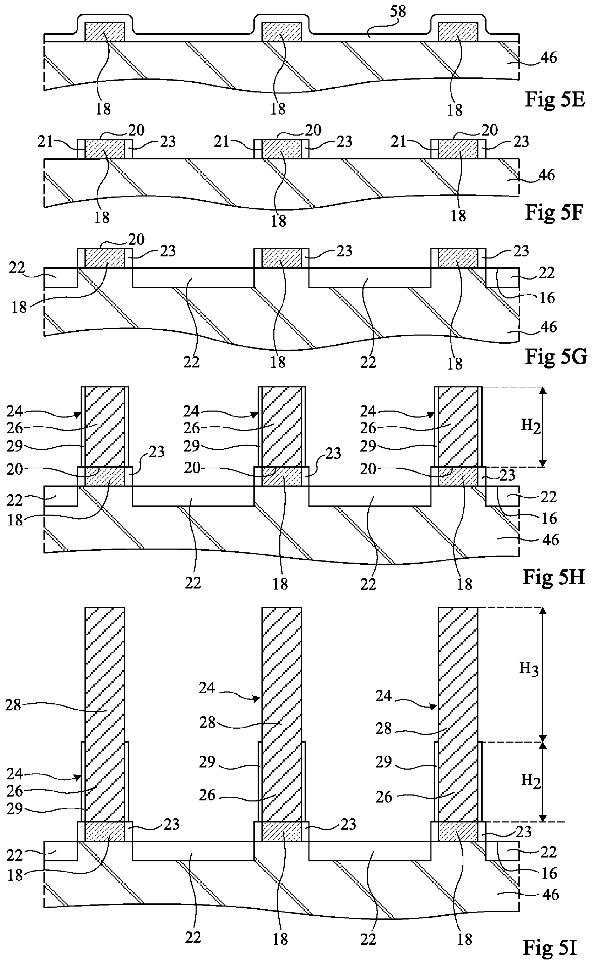

Le mode de réalisation du procédé de fabrication selon l'invention comprend les étapes suivante :
(1) Dépôt sur le substrat 46 d'une couche 50 uniforme du matériau favorisant la croissance du composé III-N, par exemple selon la polarité N (figure 5A). Il peut s'agir de nitrure d'aluminium. La couche 50 a, par exemple, une épaisseur comprise entre 1 nm et 100 nm, de préférence entre 1 nm et 50 nm. La couche 50 peut être obtenue par un procédé du type MOCVD. Toutefois, des procédés tels que CVD, MBE, GSMBE, MOMBE, ALE, HVPE, ALD (acronyme anglais pour Atomic Layer Déposition), l'évaporation ou la pulvérisation cathodique réactive peuvent être utilisés ou tout type de dépôt permettant l'obtention d'une couche texturée. Lorsque la couche 50 est en nitrure d'aluminium, la couche 50 doit être sensiblement texturée et posséder une polarité préférentielle. La texturation de la couche 50 peut être obtenue par un traitement supplémentaire réalisé après le dépôt de la couche 50. Il s'agit, par exemple, d'un recuit sous flux d'ammoniac (NH₃) . La couche 50 est fortement dopée de type N au moins sur la face en contact avec le substrat 46 et sur la face opposée. Ceci peut être réalisé par une opération de dopage en couche (en anglais delta-doping). Le substrat 46 est fortement dopé de type P au moins sur la face en contact avec la couche 50. Ce fort dopage peut être obtenu par un surdopage par diffusion ou implantation.
(2) Dépôt d'une couche 51 d'un matériau diélectrique sur la couche 50 (figure 5B). La couche 51 est en un matériau diélectrique qui peut être gravé de façon sélective par rapport au matériau formant la couche 50. Le matériau diélectrique est, par exemple, du nitrure de silicium (par exemple Si₃N₄) . La couche diélectrique 51 a, par exemple, une épaisseur comprise entre 50 et 200 nm, par exemple environ 100 nm.
(3) Gravure d'ouvertures 54 dans la couche diélectrique 51 pour former des portions 52, ou blocs, de la couche diélectrique 51 et exposer des zones de la couche 50 et gravure d'ouvertures 56 dans la couche 50 au niveau des parties exposées de la couche 50 pour former les îlots, plots 18 (figure 5C) . La gravure des ouvertures 54 peut être réalisée par une étape de gravure sélective qui n'entraîne pas de gravure de la couche 50. Il peut s'agir d'une gravure utilisant un plasma d'hexafluorure de soufre (SF₆). La gravure des ouvertures 56 peut correspondre à une gravure sèche ou humide avec arrêt sur le substrat 46. A titre d'exemple, la gravure des ouvertures 56 peut être une gravure ionique réactive ou RIE (sigle anglais pour Reactive Ion Etching), une gravure au plasma couplé par induction ou gravure ICP (sigle anglais pour Inductively Coupled Plasma) ou une gravure humide.
(4) Retrait des portions 52 (figure 5D) . Le retrait des portions 52 de la couche de diélectrique peut être réalisé par une étape de gravure sélective qui n'entraîne pas de gravure des plots 18 et du substrat 46. Il peut s'agir d'une gravure utilisant un plasma d'hexafluorure de soufre (SF₆) ou un plasma chloré, ou d'une gravure humide de type BOE (acronyme anglais pour Buffered Oxide Etch) utilisant un mélange de fluorure d'ammonium (NH₄F) et d'acide fluorhydrique (HF).
(5) Dépôt d'une couche 58 d'un matériau diélectrique sur les îlots 18 et sur le substrat 46 (figure 5E). Il s'agit, de préférence, d'un dépôt conforme ou sensiblement conforme. La couche 58 est en un matériau diélectrique qui peut être gravé de façon sélective par rapport au matériau constituant les îlots 18 et le substrat 46. La couche 58 est, par exemple, en nitrure de silicium (par exemple Si₃N₄), en oxyde de silicium (SiO₂) ou en un siliciure des matériaux décrits précédemment pour la réalisation des îlots de germination 18. La couche 58 a, par exemple, une épaisseur au moins égale à un tiers de l'épaisseur des îlots de germination 18, et, en particulier, une épaisseur comprise entre 5 nm et 200 nm, par exemple égale à environ 100 nm.
(6) Gravure anisotrope de la couche 58 pour retirer les parties de la couche 58 recouvrant le substrat 46 et les sommets 20 des îlots 18 et conserver les parties 23 de la couche 58 recouvrant les flancs latéraux 21 des îlots 18 (figure 5F). Il s'agit d'une gravure sélective par rapport au matériau constituant le substrat 46 et au matériau constituant les îlots de germination 18. Il s'agit, par exemple, d'une gravure ionique ou d'une gravure par ions réactifs.
(7) Formation de la région 22 par un procédé de nitruration des zones exposées du substrat 46 (figure 5G) non recouvertes par les îlots 18. La région 22 est essentiellement constituée de nitrure de silicium. La profondeur de nitrure de silicium obtenue doit être suffisante pour prévenir toute attaque de l'élément du groupe III, par exemple le gallium, contre le matériau constituant le substrat 46. La profondeur de la région 22 peut être comprise entre 5 nm et 100 nm, de préférence supérieure ou égale à 10 nm. La région 22 peut s'étendre en partie sous les îlots 18. Les conditions de nitruration sont choisies de façon que le substrat 46 reste néanmoins en contact électrique avec chaque îlot 18. En outre, une surépaisseur peut apparaître au niveau de la région 22. L'étape de nitruration peut être réalisée avec de l'ammoniac dans un four dédié ou dans un réacteur d'épitaxie. La température de nitruration peut varier de 900 à 1100°C et la durée de nitruration peut varier de quelques minutes à une heure. On obtient, en outre, une nitruration des sommets 20 des îlots 18 favorables à la croissance ultérieure des portions inférieures 26 des fils 24. Le procédé de nitruration peut être réalisé en plusieurs étapes. A titre d'exemple, notamment lorsque les îlots sont en aluminium (éventuellement dopé au silicium), l'étape de nitruration peut comprendre une première phase de nitruration réalisée à une première température, par exemple comprise entre 400 et 750°C, suivie d'une deuxième phase de nitruration réalisée à une deuxième température strictement supérieure à la première température, par exemple comprise entre 800 et 1100°C. La première phase favorise la nitruration du sommet 20 de chaque îlot 18 tandis que la deuxième phase favorise la nitruration des parties du substrat 46 non recouvertes par les îlots 18.
(8) Croissance de la portion passivée 26 de chaque fil 24 sur la hauteur H₂ (figure 5H). Chaque fil 24 croît depuis la face 20 au sommet d'un îlot de germination 18. La portion inférieure 26 de chaque fil 24 peut être obtenue par un procédé du type MOCVD. Toutefois, des procédés tels que CVD, MBE, GSMBE, MOMBE, PAMBE, ALE, HVPE, ou électro-chimiques peuvent être utilisés.

A titre d'exemple, dans le cas où la portion inférieure 26 est en GaN fortement dopé de type N, un procédé du type MOCVD peut être mis en oeuvre par injection dans un réacteur MOCVD, de type douchette, d'un gaz précurseur du gallium, par exemple le triméthylgallium (TMGa) et d'un gaz précurseur de l'azote, par exemple l'ammoniac (NH₃). A titre d'exemple, on peut utiliser un réacteur MOCVD 3x2", de type douchette, commercialisé par la société AIXTRON. Un rapport de flux moléculaires entre le triméthylgallium et l'ammoniac dans la gamme 5-200, de préférence dans la gamme 10-100, permet de favoriser la croissance de fils. A titre d'exemple, un gaz porteur qui assure la diffusion des organométalliques jusque dans le réacteur vient se charger en organométalliques dans un bulleur de TMGa. Celui-ci est réglé selon les conditions standard de fonctionnement. Un flux de 60 sccm (centimètres cubes standard par minute) est, par exemple choisi pour le TMGa, tandis qu'un flux de 300 sccm est utilisé pour le NH₃ (bouteille standard de NH₃). On utilise une pression d'environ 800 mbar (800 hPa). Le mélange gazeux comprend, en outre, l'injection de silane dans le réacteur MOCVD, matériau précurseur du silicium. Le silane peut être dilué dans de l'hydrogène à 1000 ppm et l'on apporte un flux de 20 sccm. La température dans le réacteur est, par exemple, comprise entre 950°C et 1100°C, de préférence entre 990°C et 1060°C. Pour transporter les espèces de la sortie des bulleurs aux deux plénums du réacteur, on utilise un flux de gaz porteur, par exemple du N₂, de 2000 sccm réparti dans les deux plénums. Les flux de gaz indiqués précédemment sont donnés à titre indicatif et sont à adapter en fonction de la taille et des spécificités du réacteur.

La présence de silane parmi les gaz précurseurs entraîne l'incorporation de silicium au sein du composé GaN. En outre, ceci se traduit par la formation de la couche 29 de nitrure de silicium qui recouvre le pourtour de la portion 26 de hauteur H₂, à l'exception du sommet au fur et à mesure de la croissance de la portion 26.
(9) Croissance de la portion supérieure 28 de hauteur H₃ de chaque fil 24 (figures 5I) sur le sommet de la portion inférieure 26. Pour la croissance de la portion supérieure 28, les conditions de fonctionnement du réacteur MOCVD décrites précédemment sont, à titre d'exemple, maintenues à l'exception du fait que le flux de silane dans le réacteur est réduit, par exemple d'un facteur supérieur ou égal à 10, ou arrêté. Même lorsque le flux de silane est arrêté, une portion active peut être dopée de type N en raison de la diffusion dans cette portion active de dopants provenant des portions passivées adjacentes ou en raison du dopage résiduel du GaN.

Le procédé comprend les étapes supplémentaires suivante :
(10) Formation, pour chaque fil 24, de la couche active 30 par épitaxie. Compte tenu de la présence de la portion passivante 23 sur les flancs latéraux 21 de l'îlot de germination 18 et portion passivante 29 recouvrant le pourtour de la portion inférieure 26, le dépôt de la couche active 30 ne se produit que sur la portion supérieure 28 du fil 24 ;
(11) Formation par épitaxie, pour chaque fil 24, de la couche de blocage d'électrons 40 et de la couche semiconductrice 42 ;
(12) Formation des portions isolantes 34. Les portions isolantes 34 peuvent être formées par le dépôt conforme d'une couche isolante sur la totalité de la structure, le dépôt d'une couche de résine entre les fils 24, la gravure de la couche isolante non recouverte par la résine pour découvrir la couche semiconductrice 42 et le retrait de la résine.
(13) Formation des portions réfléchissantes 36 ; et
(14) Formation des électrodes 38 et 12.

Selon une variante du dispositif optoélectronique 45 décrit précédemment, la protection des flancs latéraux 21 des plots 18 et la protection de la face 16 du substrat 46 peut être réalisée en formant, après la réalisation des plots 18, une région diélectrique recouvrant les parties de la face 16 du substrat 46 non déjà recouvertes par les plots 18 et recouvrant, en outre, les flancs latéraux 21 des plots 18.

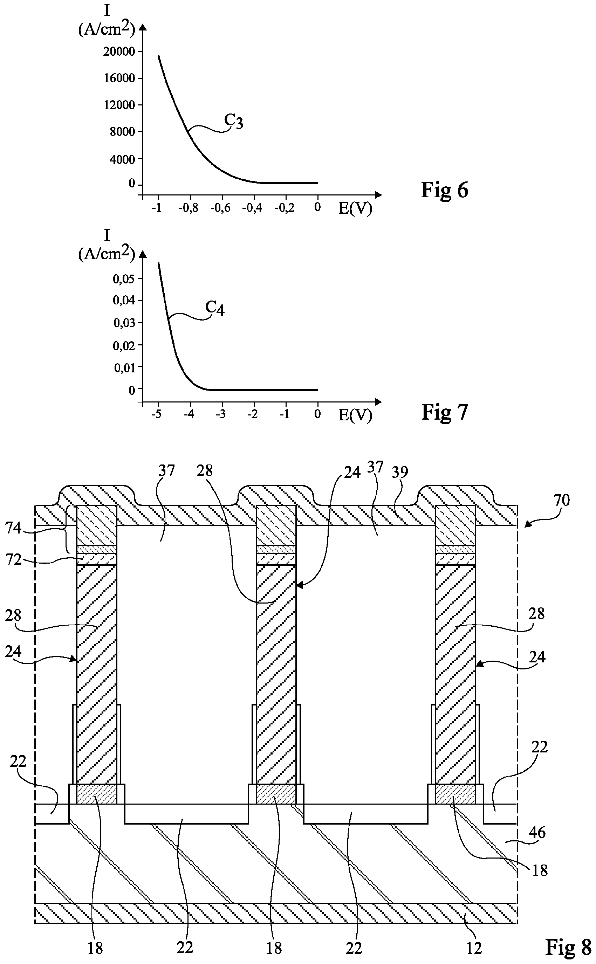

La figure 6 représente une courbe C₃ d'évolution de l'intensité du courant surfacique traversant des îlots de germination 18 d'épaisseur 15 nm en fonction de la tension appliquée entre les électrodes 38 et 12. La courbe C₃ a été obtenue avec un substrat 46 de silicium dopé de type P avec une concentration de dopants de 10²⁰ atomes/cm³, avec des îlots de germination de AlN dopés de type N avec une concentration de dopants de 10²⁰ atomes/cm³ et avec des fils 24 de GaN dont les portions inférieures 26 sont dopées de type N avec une concentration de dopants de 10²⁰ atomes/cm³. La courbe C₃ met en évidence le passage d'un courant au travers des îlots de germination 18 dès que la tension est inférieure à -0,4 V.

La figure 7 représente une courbe C₄ d'évolution du courant traversant des îlots de germination 18 obtenue pour un dispositif optoélectronique identique à celui qui a été utilisé pour obtenir la courbe C₃ de la figure 6 à la différence que la concentration de dopants de chaque îlot de germination 18 était d'environ 10¹⁹ atomes/cm³. Comme cela apparaît en figure 3, lorsque la concentration de dopants des îlots de germination 18 n'est pas suffisante, il n'est pas observé de passage de courant au travers des îlots de germination 18 pour une tension de polarisation entre -4 V et 0 V.

La figure 8 est une coupe, partielle et schématique, d'un autre mode de réalisation d'un dispositif optoélectronique 70, selon la présente invention, qui est adapté pour émettre un rayonnement électromagnétique. Le dispositif 70 diffère du dispositif 45 notamment par la forme de la portion active de chaque fil 24. En effet, pour chaque fil 24, la portion active 72 recouvre seulement le sommet du fil 24. La portion active 72 peut avoir la même composition que la couche active 30 décrite précédemment. En outre, un empilement de portions semiconductrices 74 recouvre la portion active 72. L'empilement de couches semiconductrices 74 peut avoir la même composition que l'empilement 32 décrit précédemment.

Des modes de réalisation particuliers de la présente invention ont été décrits. Diverses variantes et modifications apparaîtront à l'homme de l'art. En particulier, bien qu'on ait représenté sur les figures des modes de réalisation dans lesquels les fils, recouverts d'une première électrode, sont formés sur une première face d'un support tandis qu'une deuxième électrode est formée sur une deuxième face du support, opposée à la première face, il est toutefois clair que la deuxième électrode peut être prévue du côté de la première face.

De plus, bien que, dans les modes de réalisation décrits précédemment, chaque fil 24 comprenne une portion passivée 26, à la base du fil en contact avec le sommet 20 d'un îlot de germination 18, cette portion passivée 26 peut ne pas être présente.

De plus, si les différents modes de réalisation de dispositifs optoélectroniques décrits précédemment sont adaptés pour émettre un rayonnement électromagnétique, de tels dispositifs peuvent aisément être adaptés par un homme du métier pour recevoir un rayonnement électromagnétique et le convertir en un signal électrique. La couche active 30 est alors la couche dans laquelle est capturée la majorité du rayonnement reçu par le dispositif. Une telle adaptation est réalisée en adaptant à la fois la couche active 30, 72 de chacun des fils 24 et en appliquant sur la structure semiconductrice une polarisation adéquate. Une telle adaptation du dispositif 45, 70 peut être réalisée, en accord avec la présente invention, pour former soit un dispositif optoélectronique dédié à la mesure ou la détection d'un rayonnement électromagnétique, soit un dispositif optoélectronique dédié aux applications photovoltaïques.

En outre, bien que des modes de réalisation aient été décrits pour un dispositif optoélectronique comprenant des îlots de germination recouvrant un substrat, il est clair que le dispositif optoélectronique peut comprendre une couche de germination recouvrant le substrat, la couche de germination étant elle-même recouverte d'une couche isolante dans laquelle sont prévues des ouvertures pour exposer des parties de la couche de germination, les fils croissant dans les ouvertures. Dans ce cas, la jonction tunnel est réalisée sur la totalité de l'interface entre la couche de germination et le substrat sous-jacent.

## Revendications

1. Dispositif optoélectronique (45 ; 70) comprenant :
un substrat (46) semiconducteur dopé d'un premier type de conductivité ;
des plots semiconducteurs (18) ou une couche semiconductrice sur une face (16) du substrat et en contact avec le substrat, dopés, respectivement dopée, d'un second type de conductivité opposé au premier type; et
des éléments semiconducteurs tridimensionnels (24), chaque élément semiconducteur étant en contact avec un plot ou avec la couche,
dans lequel le substrat est en un premier matériau semiconducteur choisi parmi le groupe comprenant le silicium, le germanium, un alliage silicium-germanium, le carbure de silicium, un composé III-V, tel que du GaN, du GaAs, du GaP ou du GaSb, ou le ZnO et une combinaison de ces composés,
dans lequel les plots semiconducteurs ou la couche semiconductrice sont en un matériau choisi parmi le groupe comprenant le nitrure d'aluminium, le nitrure de bore, le carbure de silicium, le nitrure de magnésium, le nitrure de gallium et de magnésium ou en une combinaison de ceux-ci et de leurs composés nitrurés,
dans lequel chaque élément semiconducteur est au moins partiellement recouvert d'une structure semiconductrice (30; 72) adaptée à émettre ou capter de la lumière,
dans lequel la concentration de dopants des plots (18) ou de la couche est strictement supérieure à 10¹⁹ atomes/cm³ et
dans lequel la concentration de dopants du substrat (46) est strictement supérieure à 10¹⁹ atomes/cm³.

2. Dispositif optoélectronique selon la revendication 1, dans lequel chaque élément semiconducteur comprend au moins une partie (26), en contact avec le plot associé ou la couche, dopée du second type de conductivité.

3. Dispositif optoélectronique selon la revendication 2, dans lequel, pour chaque élément semiconducteur, la concentration de dopants de la partie de l'élément semiconducteur (24) est strictement supérieure à 10¹⁹ atomes/cm³.

4. Dispositif optoélectronique selon l'une quelconque des revendications 1 à 3, comprenant, en outre, une portion (23) recouvrant au moins les flancs latéraux (21) de chaque plot, ladite portion empêchant la croissance des éléments semiconducteurs sur les flancs latéraux.

5. Dispositif optoélectronique selon l'une quelconque des revendications 1 à 4, comprenant, en outre, une région (22) diélectrique s'étendant dans le substrat (46) depuis ladite face (16) et reliant, pour chaque paire de plots (18), l'un des plots de la paire à l'autre plot de la paire.

6. Dispositif optoélectronique selon l'une quelconque des revendications 1 à 5, dans lequel le substrat (46) est en silicium.

7. Dispositif optoélectronique selon la revendication 2, dans lequel ladite partie (26) comprend majoritairement un deuxième matériau semiconducteur choisi parmi le groupe comprenant le silicium, le germanium, le carbure de silicium, un composé III-V, un composé II-VI et une combinaison de ces composés.

8. Dispositif optoélectronique selon l'une quelconque des revendications 1 à 7, dans lequel l'épaisseur de chaque plot (18) est comprise entre 1 nm et 100 nm et dans lequel le substrat (46) est en contact électrique avec chaque plot (18).

9. Dispositif optoélectronique selon l'une quelconque des revendications 1 à 8, dans lequel chaque élément semiconducteur (24) est un microfil, un nanofil ou un élément conique ou tronconique à base polygonale.

10. Procédé de fabrication d'un dispositif optoélectronique (45 ; 70), comprenant les étapes successives suivante :
prévoir un substrat (46) semiconducteur dopé d'un premier type de conductivité ;
former, sur une face (16) du substrat et en contact avec le substrat, des plots semiconducteurs (18) ou une couche semiconductrice dopés, respectivement dopée, d'un second type de conductivité opposé au premier type ; et
former des éléments semiconducteurs tridimensionnels (24), chaque élément semiconducteur étant en contact avec un plot ou avec la couche,
dans lequel le substrat est en un premier matériau semiconducteur choisi parmi le groupe comprenant le silicium, le germanium, un alliage silicium-germanium, le carbure de silicium, un composé III-V, tel que du GaN, du GaAs, du GaP ou du GaSb, ou le ZnO et une combinaison de ces composés,
dans lequel les plots semiconducteurs ou la couche semiconductrice sont en un matériau choisi parmi le groupe comprenant le nitrure d'aluminium, le nitrure de bore, le carbure de silicium, le nitrure de magnésium, le nitrure de gallium et de magnésium ou en une combinaison de ceux-ci et de leurs composés nitrurés, dans lequel chaque élément semiconducteur est au moins partiellement recouvert d'une structure semiconductrice (30; 72) adaptée à émettre ou capter de la lumière,
dans lequel la concentration de dopants des plots (18) ou de la couche est strictement supérieure à 10¹⁹ atomes/cm³ et
dans lequel la concentration de dopants du substrat (46) est strictement supérieure à 10¹⁹ atomes/cm³.

## Patentansprüche

1. Eine optoelektronische Vorrichtung (45; 70), die Folgendes aufweist:
ein dotiertes Halbleitersubstrat (46) mit einem ersten Leitfähigkeitstyp;
Halbleiter-Kontaktfelder (18) oder eine Halbleiterschicht auf einer Oberfläche (16) des Substrats und in Kontakt mit dem Substrat, die mit einem zweiten Leitfähigkeitstyp dotiert sind, der dem ersten Typ entgegengesetzt ist; und
dreidimensionale Halbleiterelemente (24), wobei jedes Halbleiterelement in Kontakt mit einem Feld oder mit einer Schicht ist,
wobei das Substrat aus einem ersten Halbleitermaterial hergestellt ist, ausgewählt aus der Gruppe, die Silizium, Germanium, eine Silizium-Germanium-Legierung, Siliziumcarbid, eine III-V-Verbindung wie GaN, GaAs, GaP, oder GaSb, oder ZnO, und eine Kombination dieser Verbindungen aufweist,
wobei die Halbleiterfelder oder die Halbleiterschicht aus einem Material hergestellt sind, ausgewählt aus der Gruppe, die Aluminiumnitrid, Boronnitrid, Siliziumcarbid, Magnesiumnitrid, Magnesiumgalliumnitrid, oder einer Kombination derselben und ihrer nitridierten Verbindungen aufweist,
wobei jedes Halbleiterelement wenigstens teilweise mit einer Halbleiterstruktur (30; 72) abgedeckt ist, die geeignet ist, Licht abzugeben oder einzufangen,
wobei die Dotiermittelkonzentration der Felder (18) oder der Schicht größer als 10⁹ Atome/cm³ ist, und
wobei die Dotiermittelkonzentration des Substrats (46) größer als 10⁹ Atome/cm³ ist.

2. Optoelektronische Vorrichtung nach Anspruch 1, wobei jedes Halbleiterelement wenigstens ein Teil (26) aufweist, das in Kontakt mit dem dazugehörigen Feld oder der Schicht ist, die mit dem zweiten Leitfähigkeitstyp dotiert ist.

3. Optoelektronische Vorrichtung nach Anspruch 2, wobei für jedes Halbleiterelement die Dotiermittelkonzentration des Teils des Halbleiterelements (24) größer als 10⁹ Atome/cm³ ist.

4. Optoelektronische Vorrichtung nach einem der Ansprüche 1 bis 3, die ferner ein Teil (23) aufweist, das wenigstens die Seitenflächen (21) jedes Feldes abdeckt, und das Teil den Wachstum der Halbleiterelemente an den Seitenflächen verhindert.

5. Optoelektronische Vorrichtung nach einem der Ansprüche 1 bis 4, die ferner einen dielektrischen Bereich (22) aufweist, der sich von der Oberfläche (16) in das Substrat (46) erstreckt und bei jedem Paar von Feldern (18) eines der Felder in dem Paar mit dem anderen Feld in dem Paar verbindet.

6. Optoelektronische Vorrichtung nach einem der Ansprüche 1 bis 5, wobei das Substrat (46) aus Silizium besteht.

7. Optoelektronische Vorrichtung nach Anspruch 2, wobei das Teil (26) hauptsächlich ein zweites Halbleitermaterial aus der Gruppe aufweist, die Silizium, Germanium, Siliziumcarbid, eine III-V-Verbindung, eine II-VI-Verbindung und eine Kombination dieser Verbindungen aufweist.

8. Optoelektronische Vorrichtung nach einem der Ansprüche 1 bis 7, wobei die Dicke jedes Feldes (18) im Bereich von 1 nm bis 100 nm liegt und wobei das Substrat (46) in elektrischem Kontakt mit jedem Feld (18) ist.

9. Optoelektronische Vorrichtung nach einem der Ansprüche 1 bis 8, wobei jedes Halbleiterelement (24) eine Mikroleitung, eine Nanoleitung, ein kegelförmiges oder ein sich verjüngendes Element mit einer mehreckigen Basis ist.

10. Ein Verfahren zur Herstellung einer optoelektronischen Vorrichtung (45; 70), das folgende aufeinanderfolgende Schritte aufweist:
Bereitstellen eines dotierten Halbleitersubstrats (46) eines ersten Leitfähigkeitstyps;
Bilden von Halbleiterfeldern (18) oder einer Halbleiterschicht auf einer Oberfläche (16) des Substrats und in Kontakt mit dem Substrat, die dotiert sind mit einem zweiten Leitfähigkeitstyp entgegengesetzt zu dem ersten Typ; und
Bilden dreidimensionaler Halbleiterelemente (24), wobei jedes Halbleiterelement in Kontakt mit einem Feld oder mit der Schicht ist,
wobei das Substrat aus einem ersten Halbleitermaterial hergestellt ist, ausgewählt aus der Gruppe, die Silizium, Germanium, eine Silizium-Germanium-Legierung, Siliziumcarbid, eine III-V-Verbindung, wie GaN, GaAs, GaP, oder GaSb, oder ZnO, und einer Kombination dieser Verbindungen aufweist,
wobei die Halbleiterfelder oder die Halbleiterschicht aus einem Material hergestellt sind, ausgewählt aus der Gruppe, die Aluminiumnitrid, Boronnitrid, Siliziumcarbid, Magnesiumnitrid, Magnesiumgalliumnitrid, oder einer Kombination davon und ihrer nitridierten Verbindungen aufweist,
wobei jedes Halbleiterelement wenigstens teilweise mit einer Halbleiterstruktur (30; 72) abgedeckt ist, die geeignet ist, Licht abzugeben oder einzufangen,
wobei die Dotiermittelkonzentration der Felder (18) oder der Schicht größer als 10⁹ Atome/cm³ ist, und
wobei die Dotiermittelkonzentration des Substrats (46) größer als 10⁹ Atome/cm³ ist.

## Claims

1. An optoelectronic device (45; 70) comprising:
a doped semiconductor substrate (46) of a first conductivity type;
semiconductor pads (18) or a semiconductor layer on a surface (16) of the substrate and in contact with the substrate, doped with a second conductivity type opposite to the first type; and
tridimensional semiconductor elements (24), each semiconductor element being in contact with a pad or with the layer,
wherein the substrate is made of a first semiconductor material selected from the group comprising silicon, germanium, a silicon-germanium alloy, silicon carbide, a III-V compound, such as GaN, GaAs, GaP, or GaSb, or ZnO, and a combination of these compounds,
wherein the semiconductor pads or the semiconductor layer are made of a material selected from the group comprising aluminum nitride, boron nitride, silicon carbide, magnesium nitride, magnesium gallium nitride, or a combination thereof and of their nitrided compounds,
wherein each semiconductor element is at least partially covered with a semiconductor structure (30; 72) capable of emitting or of capturing light,
wherein the dopant concentration of the pads (18) or of the layer is greater than 10¹⁹ atoms/cm³, and
wherein the dopant concentration of the substrate (46) is greater than 10¹⁹ atoms/cm³.

2. The optoelectronic device of claim 1, wherein each semiconductor element comprises at least a portion (26), in contact with the associated pad or with the layer, doped with the second conductivity type.

3. The optoelectronic device of claim 2, wherein, for each semiconductor elements, the dopant concentration of the portion of the semiconductor element (24) is greater than 10¹⁹ atoms/cm³.

4. The optoelectronic device of any of claims 1 to 3, further comprising a portion (23) covering at least the lateral sides (21) of each pad, said portion preventing the growth of the semiconductor elements on the lateral sides.

5. The optoelectronic device of any of claims 1 to 4, further comprising a dielectric region (22) extending in the substrate (46) from said surface (16) and connecting, for each pair of pads (18), one of the pads in the pair to the other pad in the pair.

6. The optoelectronic device of any of claims 1 to 5, wherein the substrate (46) is made of silicon.

7. The optoelectronic device of claim 2, wherein said portion (26) mainly comprises a second semiconductor material selected from the group comprising silicon, germanium, silicon carbide, a III-V compound, a II-VI compound, and a combination of these compounds.

8. The optoelectronic device of any of claims 1 to 7, wherein the thickness of each pad (18) is in the range from 1 nm to 100 nm and wherein the substrate (46) is in electric contact with each pad (18).

9. The optoelectronic device of any of claims 1 to 8, wherein each semiconductor element (24) is a microwire, a nanowire, a conical or tapered element with a polygonal base.

10. A method of manufacturing an optoelectronic device (45; 70), comprising the successive steps of:
providing a doped semiconductor substrate (46) of a first conductivity type;
forming, on a surface (16) of the substrate and in contact with the substrate, semiconductor pads (18) or a semiconductor layer doped with a second conductivity type opposite to the first type; and
forming tridimensional semiconductor elements (24), each semiconductor element being in contact with a pad or with the layer,
wherein the substrate is made of a first semiconductor material selected from the group comprising silicon, germanium, a silicon-germanium alloy, silicon carbide, a III-V compound, such as GaN, GaAs, GaP, or GaSb, or ZnO, and a combination of these compounds,
wherein the semiconductor pads or the semiconductor layer are made of a material selected from the group comprising aluminum nitride, boron nitride, silicon carbide, magnesium nitride, magnesium gallium nitride, or a combination thereof and of their nitrided compounds,
wherein each semiconductor element is at least partially covered with a semiconductor structure (30; 72) capable of emitting or of capturing light,
wherein the dopant concentration of the pads (18) or of the layer is greater than 10¹⁹ atoms/cm³, and
wherein the dopant concentration of the substrate (46) is greater than 10¹⁹ atoms/cm³.
